# EUROPEAN PATENT APPLICATION

(11) **EP 4 318 004 A1**
(43) Date of publication of application: **07.02.2024**
(21) Application number: 22779715.6
(22) Date of filing: 25.02.2022
(51) Int. Cl.: G01R 31/34, G01R 31/56

(54) **INSULATION RESISTANCE MONITORING DEVICE**

(30) Priority: 29.03.2021 JP 2021056106
(71) Applicant: OMRON Corporation, Kyoto 600-8530 (JP)
(72) Inventor: TAKATANI, Ryohei, Kyoto-shi, Kyoto 600-8530 (JP); YAMAGUCHI, Shohei, Kyoto-shi, Kyoto 600-8530 (JP); OZAKI, Masahiro, Kyoto-shi, Kyoto 600-8530 (JP)
(74) Representative: HGF
(86) International application number: PCT/JP2022/007957
(87) International publication number: WO 2022/209490

(57) **Abstract**

An insulation resistance measuring unit measures and outputs an insulation resistance of a device under measurement. An operation information receiver (44) receives information indicating whether or not the device under measurement is in operation. A humidity information receiver (45) receives humidity around the device under measurement. A controller (46) controls the insulation resistance measuring unit to measure and output the insulation resistance of the device under measurement, when the device under measurement is not in operation, and the humidity around the device under measurement is equal to or higher than a first threshold (Th1).

## Description

### TECHNICAL FIELD

The present disclosure relates to an insulation resistance monitoring apparatus.

### BACKGROUND ART

The Electricity Business Act mandates regular inspections of electric facilities, such as high-voltage substation facilities and distribution boards, at yearly frequency. In addition, businesses also conduct voluntary inspection on electric equipment, such as a motor connected to a power distribution board, at weekly to monthly frequency, in accordance with their own management policy.

However, there are too many devices potentially subjected to voluntary inspections (device under measurement), including wide varieties of electric facilities and electric equipment, and therefore, it is difficult to actually conduct the inspections. To address this issue, insulation resistance monitoring apparatuses have been developed for automated voluntary inspections.

For example, Patent Document 1 discloses an insulation resistance monitoring apparatus provided with a switch for opening and closing a connection path between a power line or a ground line of a device under measurement, and a voltage source of the insulation resistance monitoring apparatus.

### CITATION LIST

### PATENT DOCUMENTS

PATENT DOCUMENT 1: Japanese Patent Laid-open Publication No. JP 2020-148736 A

### SUMMARY OF INVENTION

### TECHNICAL PROBLEM

The insulation resistance of the device under measurement may vary depending on the conditions of the surrounding environment of the device under measurement. Therefore, a temporarily increased insulation resistance may be obtained, and as a result, a degradation in the insulation performance, for which the device under measurement is to be inspected, may be overlooked. In addition, when the insulation resistance has changed, it is not possible to determine whether the change has occurred due to the surrounding environment, or due to a degradation in the insulation performance. Therefore, it is necessary to accurately measure the insulation resistance of the device under measurement, in consideration of variations in the insulation resistance due to the surrounding environment of the device under measurement.

An object of the present disclosure is to provide an insulation resistance monitoring apparatus capable of accurately measuring the insulation resistance of a device under measurement, in consideration of variations in the insulation resistance due to the surrounding environment of the device under measurement.

### SOLUTION TO PROBLEM

According an insulation resistance monitoring apparatus of an aspect of the present invention, the insulation resistance monitoring apparatus is provided with: an insulation resistance measuring unit, an operation information receiver, a humidity information receiver, and a controller. The insulation resistance measuring unit is configured to measure and output an insulation resistance of a device under measurement. The operation information receiver is configured to receive information indicating whether or not the device under measurement is in operation. The humidity information receiver is configured to receive humidity around the device under measurement. The controller is configured to control the insulation resistance measuring unit to measure and output the insulation resistance of the device under measurement, when the device under measurement is not in operation, and the humidity around the device under measurement is equal to or higher than a first threshold.

With such a configuration, it is possible to accurately measure the insulation resistance of the device under measurement, in consideration of variations in the insulation resistance due to the surrounding environment of the device under measurement.

According an insulation resistance monitoring apparatus of an aspect of the present invention, the insulation resistance monitoring apparatus is further provided with a timer configured to measure a time elapsed from when the device under measurement stopped operation. When the device under measurement is not in operation, a predetermined first time period has elapsed from when the device under measurement stopped operation, and the humidity around the device under measurement is equal to or higher than the first threshold, the controller controls the insulation resistance measuring unit to measure and output the insulation resistance of the device under measurement.

With such a configuration, it is possible to accurately measure the insulation resistance of the device under measurement, in consideration of variations in the humidity due to the operation of the device under measurement.

According an insulation resistance monitoring apparatus of an aspect of the present invention, the insulation resistance monitoring apparatus is further provided with a storage configured to store the insulation resistance of the device under measurement measured by the insulation resistance measuring unit. The controller is configured to set the first threshold by: controlling the insulation resistance measuring unit to measure the insulation resistance of the device under measurement over a predetermined second time period; storing, in the storage, the insulation resistance of the device under measurement measured by the insulation resistance measuring unit, and the humidity around the device under measurement received when measuring the insulation resistance of the device under measurement; and selecting humidity corresponding to a lowest insulation resistance among a plurality of insulation resistances stored in the storage, as the first threshold.

With such a configuration, it is possible to automatically set appropriate humidity threshold based on the surrounding environment of the device under measurement, and accurately measure the insulation resistance of the device under measurement.

According an insulation resistance monitoring apparatus of an aspect of the present invention, the controller is configured to set the first threshold, when a period in which the humidity around the device under measurement is lower than the first threshold exceeds a predetermined third time period.

With such a configuration, even if the surrounding environment of the device under measurement varies, by setting the humidity threshold again, it is possible to prevent failure in measurement of the insulation resistance Ro of the device under measurement for a long time.

According an insulation resistance monitoring apparatus of an aspect of the present invention, the insulation resistance monitoring apparatus is further provided with a temperature information receiver configured to receive a temperature around the device under measurement. When the device under measurement is not in operation, the humidity around the device under measurement is equal to or higher than the first threshold, and the temperature around the device under measurement is equal to or higher than a second threshold, the controller controls the insulation resistance measuring unit to measure and output the insulation resistance of the device under measurement.

With such a configuration, it is possible to accurately measure the insulation resistance of the device under measurement, in consideration of variations in the insulation resistance due to the surrounding environment of the device under measurement.

According an insulation resistance monitoring apparatus of an aspect of the present invention, the insulation resistance monitoring apparatus is further provided with a timer configured to measure a time elapsed from when the device under measurement stopped operation. When the device under measurement is not in operation, a predetermined first time period has elapsed from when the device under measurement has stopped operation, the humidity around the device under measurement is equal to or higher than the first threshold, and the temperature around the device under measurement is equal to or higher than the second threshold, the controller controls the insulation resistance measuring unit to measure and output the insulation resistance of the device under measurement.

With such a configuration, it is possible to accurately measure the insulation resistance of the device under measurement, in consideration of variations in the humidity due to the operation of the device under measurement.

According an insulation resistance monitoring apparatus of an aspect of the present invention, the insulation resistance monitoring apparatus is further provided with a storage configured to store the insulation resistance of the device under measurement measured by the insulation resistance measuring unit. The controller is configured to set the second threshold by: controlling the insulation resistance measuring unit to measure the insulation resistance of the device under measurement over a predetermined second time period; storing, in the storage, the insulation resistance of the device under measurement measured by the insulation resistance measuring unit, and the temperature around the device under measurement received when the insulation resistance of the device under measurement is measured; and selecting a temperature corresponding to a lowest insulation resistance among a plurality of the insulation resistances stored in the storage, as the second threshold.

With such a configuration, it is possible to automatically set appropriate temperature threshold based on the surrounding environment of the device under measurement, and accurately measure the insulation resistance of the device under measurement.

According an insulation resistance monitoring apparatus of an aspect of the present invention, the controller sets the second threshold, when a period in which the temperature around the device under measurement is less than the second threshold exceeds a predetermined third time period.

With such a configuration, even if the surrounding environment of the device under measurement varies, by setting the temperature threshold again, it is possible to prevent failure in measurement of the insulation resistance Ro of the device under measurement for a long time.

### ADVANTAGEOUS EFFECTS OF INVENTION

According to the insulation resistance monitoring apparatus of one aspect of the present invention, it is possible to accurately measure the insulation resistance of the device under measurement, in consideration of variations in the insulation resistance due to the surrounding environment of the device under measurement.

### BRIEF DESCRIPTION OF DRAWINGS

Fig. 1 is a block diagram showing an exemplary configuration of a motor system including an insulation resistance monitoring apparatus 40 according to a first embodiment.
Fig. 2 is a graph showing exemplary characteristics of an insulation resistance Ro of a three-phase motor apparatus 30 of Fig. 1, with respect to humidity and temperature.
Fig. 3 is an exemplary timing chart showing measurements of the insulation resistance Ro of the three-phase motor apparatus 30, conducted by the insulation resistance monitoring apparatus 40 shown in Fig. 1.
Fig. 4 is a flowchart showing an example of an insulation resistance monitoring process executed by a controller 46 of Fig. 1.
Fig. 5 is a block diagram showing an exemplary configuration of a motor system including an insulation resistance monitoring apparatus 40A according to a second embodiment.
Fig. 6 is an exemplary timing chart showing measurements of an insulation resistance Ro of a three-phase motor apparatus 30A, conducted by the insulation resistance monitoring apparatus 40A shown in Fig. 5.
Fig. 7 is a flowchart showing an example of an insulation resistance monitoring process executed by a controller 46A of Fig. 5.
Fig. 8 is a block diagram showing an exemplary configuration of a motor system including an insulation resistance monitoring apparatus 40B according to a third embodiment.
Fig. 9 is an exemplary timing chart showing measurements of the insulation resistance Ro of the three-phase motor apparatus 30, conducted by the insulation resistance monitoring apparatus 40B shown in Fig. 8.
Fig. 10 is a flowchart showing an example of an insulation resistance monitoring process executed by a controller 46B of Fig. 8.
Fig. 11 is a block diagram showing an exemplary configuration of a motor system including an insulation resistance monitoring apparatus 40C according to a fourth embodiment.
Fig. 12 is an exemplary timing chart showing measurements of an insulation resistance Ro of a three-phase motor apparatus 30A, conducted by the insulation resistance monitoring apparatus 40C shown in Fig. 11.
Fig. 13 is a table showing the insulation resistance Ro of the three-phase motor apparatus 30A measured by the insulation resistance monitoring apparatus 40C of Fig. 11 under various humidity and temperature conditions.

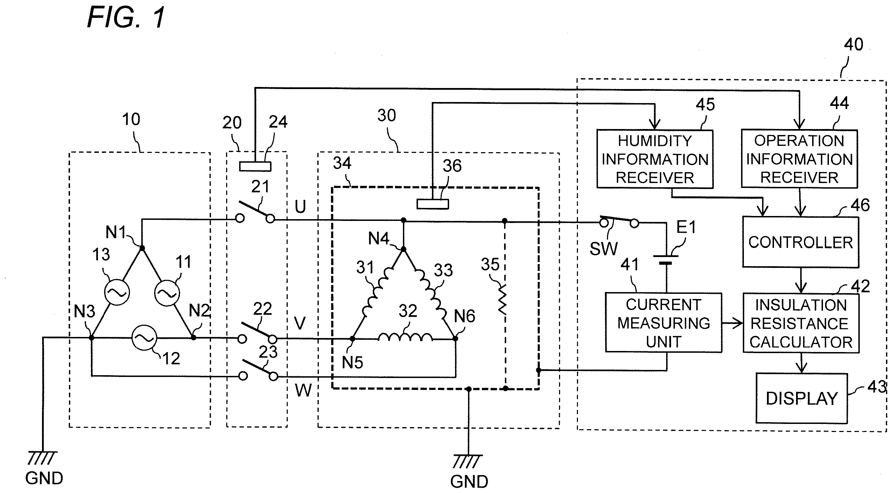

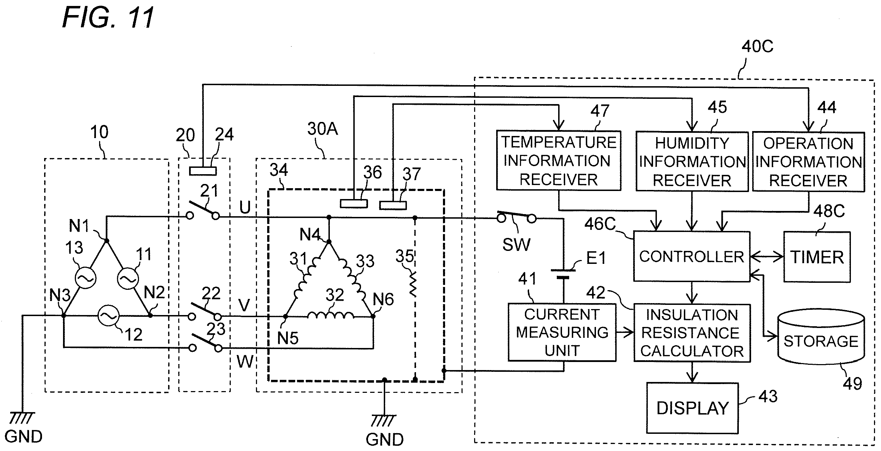

Fig. 1 4 is a flowchart showing an example of an insulation resistance monitoring process executed by a controller 46C of Fig. 11.

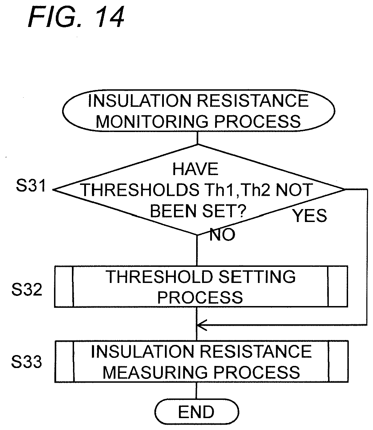

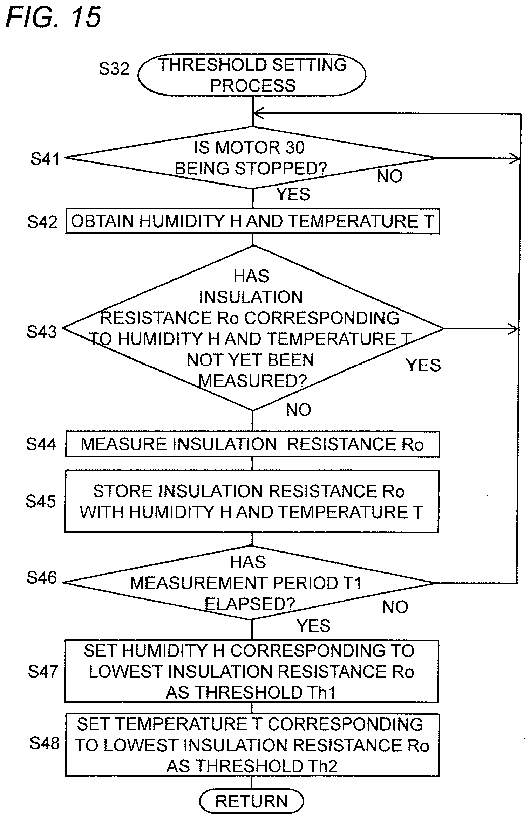

Fig. 15 is a flowchart showing a subroutine of a threshold setting process of step S32 in Fig. 14.

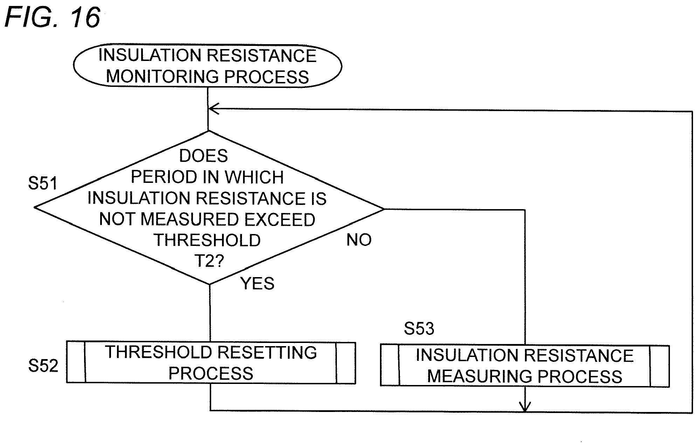

Fig. 16 is a flowchart showing a modification of the insulation resistance monitoring process executed by the controller 46C of Fig. 11.

### DESCRIPTION OF EMBODIMENTS

Embodiments according to one aspect of the present disclosure will now be explained with reference to the drawings. In the drawings, the same reference signs denote similar components.

### [APPLICATION EXAMPLE]

Fig. 1 is a block diagram showing an exemplary configuration of a motor system including an insulation resistance monitoring apparatus 40 according to a first embodiment. The motor system shown in Fig. 1 is provided with, for example, a three-phase AC power supply apparatus 10, a circuit breaker 20, a three-phase motor apparatus 30, and an insulation resistance monitoring apparatus 40. The three-phase AC power supply apparatus 10 supplies three-phase AC power to the three-phase motor apparatus 30 via the circuit breaker 20. The example of Fig. 1 shows a configuration in which the insulation resistance monitoring apparatus 40 measures an insulation resistance Ro of the three-phase motor apparatus 30 that is a device under measurement.

The insulation resistance monitoring apparatus 40 is provided with a current measuring unit 41, an insulation resistance calculator 42, a display 43, an operation information receiver 44, a humidity information receiver 45, a controller 46, a voltage source E1, and a switch SW.

The voltage source E1 supplies a voltage to be applied across two mutually insulated nodes of the three-phase motor apparatus 30. The switch SW opens and closes a circuit between the three-phase motor apparatus 30 and the voltage source E1. The current measuring unit 41 measures a leakage current flowing between two mutually insulated nodes of the three-phase motor apparatus 30, the leakage current being due to the voltage supplied by the voltage source E1. The insulation resistance calculator 42 calculates the insulation resistance Ro of the three-phase motor apparatus 30, based on the leakage current measured by the current measuring unit 41. The display 43 outputs the insulation resistance Ro calculated by the insulation resistance calculator 42.

The current measuring unit 41, the insulation resistance calculator 42, the display 43, the voltage source E1, and the switch SW configure one example of an insulation resistance measuring unit that measures and outputs the insulation resistance Ro of the three-phase motor apparatus 30.

The operation information receiver 44 receives and obtains information indicating whether or not the three-phase motor apparatus 30 is in operation. The humidity information receiver 45 receives and obtains the humidity around the three-phase motor apparatus 30. When the three-phase motor apparatus 30 is not in operation, and the humidity around the three-phase motor apparatus 30 is equal to or higher than a predetermined threshold Th1, the controller 46 controls the insulation resistance calculator 42 to measure the insulation resistance Ro of the three-phase motor apparatus 30, and to output the insulation resistance Ro on the display 43.

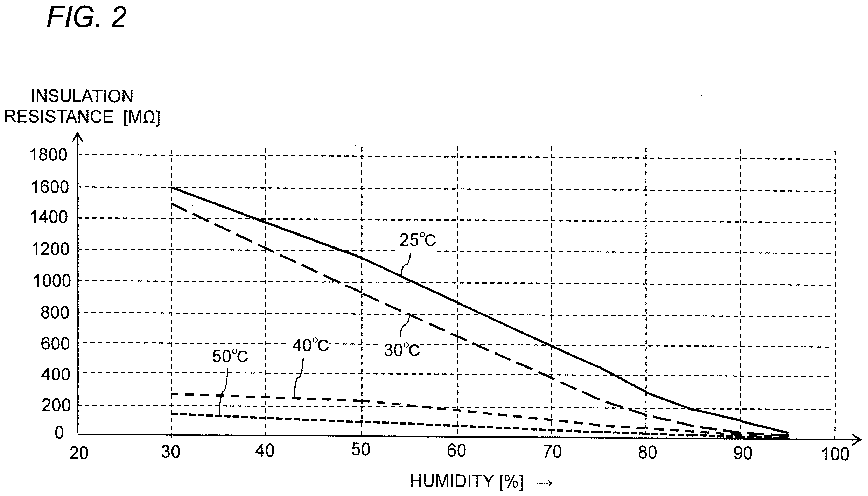

Fig. 2 is a graph showing exemplary characteristics of the insulation resistance Ro of the three-phase motor apparatus 30 of Fig. 1, with respect to the humidity and the temperature. As mentioned above, the insulation resistance of the device under measurement (e.g., the three-phase motor apparatus 30), to be measured by the insulation resistance monitoring apparatus 40, may vary depending on the conditions of the surrounding environment of the device under measurement. For example, as shown in Fig. 2, the insulation resistance of the three-phase motor apparatus 30 may vary depending on the humidity and the temperature (atmospheric temperature) around the three-phase motor apparatus 30. Referring to the example of Fig. 2, the insulation resistance decreases as the humidity increases, and the insulation resistance decreases as the temperature increases. Therefore, if the insulation resistance of the three-phase motor apparatus 30 is measured when the humidity and the temperature have temporarily decreased, a temporarily increased insulation resistance may be obtained, and as a result, a degradation in the insulation performance, for which the three-phase motor apparatus 30 is to be inspected, may be overlooked. In addition, when the insulation resistance has changed, it is not possible to determine whether the change has occurred due to the surrounding environment (i.e., humidity or temperature), or due to a degradation in the insulation performance. Therefore, it is necessary to accurately measure the insulation resistance of the device under measurement, in consideration of variations in the insulation resistance due to the surrounding environment of the device under measurement.

The insulation resistance monitoring apparatus 40 according to the first embodiment measures and outputs the insulation resistance Ro of the three-phase motor apparatus 30 when the humidity around the three-phase motor apparatus 30 is equal to or higher than the threshold Th1, but does not measure and output (at least does not output) the insulation resistance Ro when the humidity is lower than the threshold Th1. Therefore, when a high insulation resistance Ro is measured and outputted, it can be determined that the insulation performance of the three-phase motor apparatus 30 is not degraded. On the other hand, when a low insulation resistance Ro is measured and outputted, it can be determined that the insulation performance of the three-phase motor apparatus 30 has degraded. As described above, the insulation resistance monitoring apparatus 40 according to the first embodiment can accurately measure the insulation resistance Ro of the three-phase motor apparatus 30 in consideration of variations of the insulation resistance Ro due to the surrounding environment of the three-phase motor apparatus 30, and present the insulation resistance Ro to the user.

In the environment under an ordinary temperature, e.g., 20°C to 30°C, where the device under measurement is likely to be disposed, it is considered that the humidity is more dominant in the variations of the insulation resistance Ro, than the temperature. In this manner, in the first embodiment, the insulation resistance Ro of the three-phase motor apparatus 30 is measured and outputted in consideration of the humidity around the three-phase motor apparatus 30.

### [FIRST EMBODIMENT]

The insulation resistance monitoring apparatus according to the first embodiment will be further explained below.

### [EXEMPLARY CONFIGURATION OF FIRST EMBODIMENT]

The three-phase AC power supply apparatus 10 is provided with three single-phase AC power supplies 11 to 13. Each of the single-phase AC power supplies 11 to 13 generates a single-phase AC voltage with a phase shifted by 120 degrees from those of the others. In the example of Fig. 1, the single-phase AC power supplies 11 to 13 are connected to one another in the Δ connection. The single-phase AC power supplies 11 to 13 are connected to one another at nodes N1 to N3, and the nodes N1 to N3 are connected to the circuit breaker 20 and the three-phase motor apparatus 30 via the U-phase, V-phase, and W-phase power lines, respectively.

The three-phase AC power supply apparatus 10 may include a distribution board, a high-voltage substation facility, and the like. In such a case, the high-voltage substation facility steps down the voltage supplied from an electric utility company, e.g., 6600 V, to a voltage of, e.g., about 200 V to 480 V. The distribution board distributes the stepped-down voltage to the three-phase motor apparatus 30 and other loads.

The circuit breaker 20 includes switches 21 to 23 inserted into the U-phase, V-phase, and W-phase power lines, respectively. The circuit breaker 20 is also provided with an operation sensor 24 that detects whether the switch 21 to 23 are on or off, thus detecting whether or not the three-phase motor apparatus 30 is in operation. The operation sensor 24 may be, for example, another switch that is turned on and off in the same and simultaneous manner as that of the switches 21 to 23.

The three-phase motor apparatus 30 is provided with windings 31 to 33 and a housing 34. In the example of Fig. 1, the windings 31 to 33 are connected to one another in the Δ connection. The windings 31 to 33 are connected to one another at nodes N4 to N6, and the nodes N4 to N6 are connected to the U-phase, V-phase, and W-phase power lines, respectively. The housing 34 is another node that is electrically isolated from windings 31 to 33. The housing 34 may be grounded.

A leakage current may flow between the windings 31 to 33 and the housing 34. In the example of Fig. 1, a line-to-ground insulation resistor 35 appears between the node N4 and the housing 34, and a resistive leakage current flows through the line-to-ground insulation resistor 35. The line-to-ground insulation resistor 35 has an insulation resistance Ro.

The three-phase motor apparatus 30 is further provided with a humidity sensor 36 that detects humidity around the three-phase motor apparatus 30. Here, being "around" the three-phase motor apparatus 30 implies a position at which the humidity sensor 36 can detect the humidity affecting the insulation resistance Ro of the three-phase motor apparatus 30, e.g., a position inside the housing 34.

The voltage source E1 supplies a voltage to be applied across two mutually insulated nodes of the three-phase motor apparatus 30, that is, the node N4 and the housing 34 in the example of Fig. 1. The voltage source E1 supplies, a DC voltage of, e.g., 50 V.

The switch SW opens and closes the circuit between the three-phase motor apparatus 30 and the voltage source E1. Although the switch SW is inserted between the node N4 and the voltage source E1 in the example of Fig. 1, the switch SW may be inserted at a different position. The switch SW may be, for example, a mechanical switch operated by a user, or a reed relay operable in accordance with an external control signal. The resistance of the opened switch SW is set depending on a desired insulation resistance of the device under measurement. For example, when the insulation resistance Ro of the three-phase motor apparatus 30 is about 100 MΩ, the resistance of the opened switch SW is set to 100 MΩ or higher, preferably 1000 MΩ or higher.

When the switch SW is turned on, the current measuring unit 41 measures a leakage current flowing between two mutually insulated nodes of the three-phase motor apparatus 30, the leakage current being due to the voltage supplied from the voltage source E1. In the example of Fig. 1, the current measuring unit 41 measures the leakage current flowing through the line-to-ground insulation resistor 35 between the node N4 and the housing 34. The current measuring unit 41 is provided with operational amplifiers and the like, and is configured to measure a current on the order of. e.g., several µA to several tens µA.

The insulation resistance calculator 42 calculates the insulation resistance Ro of the three-phase motor apparatus 30, based on the voltage supplied by the voltage source E1, and based on the leakage current measured by the current measuring unit 41. The insulation resistance calculator 42 may determine whether or not the insulation resistance Ro satisfies legally mandated requirements. The insulation resistance calculator 42 outputs the calculated result and the determined result to the display 43.

The display 43 displays the insulation resistance Ro of the three-phase motor apparatus 30. In addition to or instead of the insulation resistance Ro, the display 43 may display whether or not the insulation resistance Ro satisfies legally mandated requirements.

The operation information receiver 44 receives information indicating whether or not the three-phase motor apparatus 30 is in operation, from the operation sensor 24, and notifies the controller 46 of the information.

The humidity information receiver 45 receives the humidity around the three-phase motor apparatus 30, from the humidity sensor 36, and notifies the controller 46 of the humidity.

When the three-phase motor apparatus 30 is not in operation, and the humidity around the three-phase motor apparatus 30 is equal to or higher than the predetermined threshold Th1, the controller 46 controls the insulation resistance calculator 42 to calculate the insulation resistance Ro of the three-phase motor apparatus 30, and to output the insulation resistance Ro on the display 43. The threshold Th1 is set such that the insulation resistance Ro of the three-phase motor apparatus 30 is sufficiently low, for example, set to 50%.

When the insulation resistance Ro of the three-phase motor apparatus 30 is measured using an insulation resistance measuring unit different from the insulation resistance monitoring apparatus 40, e.g., for the purpose of a mandatory inspection, the user turns off the circuit breaker 20 and the switch SW, and connects probes of the insulation resistance measuring unit to two mutually insulated nodes of the three-phase motor apparatus 30 (e.g., the node N4 and the housing 34). In this manner, it is possible to measure the insulation resistance Ro of the three-phase motor apparatus 30 using the insulation resistance measuring unit, without removing the insulation resistance monitoring apparatus 40 from the three-phase motor apparatus 30.

### [EXEMPLARY OPERATION OF FIRST EMBODIMENT]

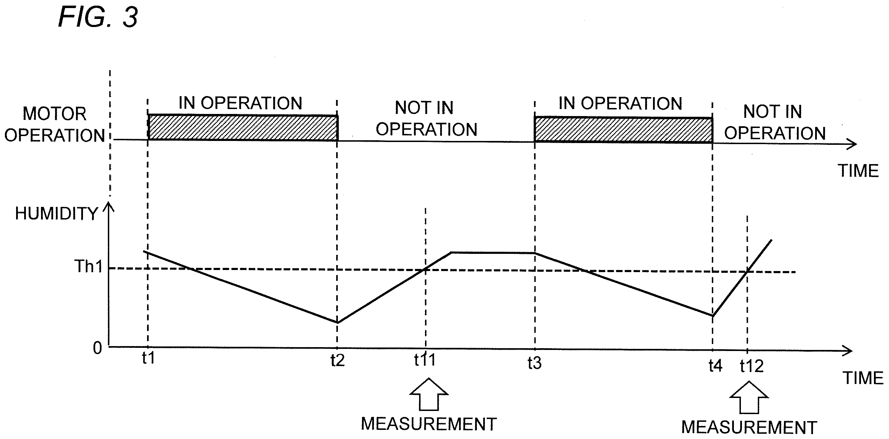

Fig. 3 is an exemplary timing chart showing measurements of the insulation resistance Ro of the three-phase motor apparatus 30, conducted by the insulation resistance monitoring apparatus 40 shown in Fig. 1. In the example of Fig. 3, the three-phase motor apparatus 30 is in operation during a time period t1 to t2 and a time period t3 to t4, and not in operation during the other time periods. In addition, when the three-phase motor apparatus 30 is not in operation, the humidity around the three-phase motor apparatus 30 exceeds the threshold Th1 at time t11 and time t12. As mentioned above, when the three-phase motor apparatus 30 is not in operation, and the humidity around the three-phase motor apparatus 30 is equal to or higher than the threshold Th1, the insulation resistance monitoring apparatus 40 measures and outputs the insulation resistance Ro of the three-phase motor apparatus 30.

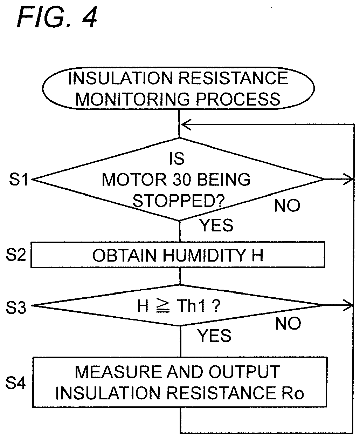

Fig. 4 is a flowchart showing an example of an insulation resistance monitoring process executed by the controller 46 of Fig. 1.

In step S1, the controller 46 determines whether or not the three-phase motor apparatus 30 is being stopped (i.e., not in operation), based on the information from the operation information receiver 44: if YES, the process proceeds to step S2; if NO, step S1 is repeated.

In step S2, the controller 46 obtains the humidity H around the three-phase motor apparatus 30, from the humidity information receiver 45. In step S3, the controller 46 determines whether or not the humidity H around the three-phase motor apparatus 30 is equal to or higher than the threshold Th1: if YES, the process proceeds to step S4; if NO, the process returns to step S1.

In step S4, the controller 46 controls the insulation resistance calculator 42 to measure the insulation resistance Ro, and to output the insulation resistance Ro on the display 43.

According to the insulation resistance monitoring process of Fig. 4, it is possible to accurately measure the insulation resistance Ro of the three-phase motor apparatus 30, in consideration of variations of the insulation resistance Ro due to variations in the humidity around the three-phase motor apparatus 30, and present the insulation resistance Ro to the user.

### [ADVANTAGEOUS EFFECTS OF FIRST EMBODIMENT]

The insulation resistance monitoring apparatus 40 according to the first embodiment can accurately measure the insulation resistance Ro of the three-phase motor apparatus 30, in consideration of variations of the insulation resistance Ro due to variations in the humidity around the three-phase motor apparatus 30, and present the insulation resistance Ro to the user.

### [SECOND EMBODIMENT]

An insulation resistance monitoring apparatus according to a second embodiment will now be explained.

### [EXEMPLARY CONFIGURATION OF SECOND EMBODIMENT]

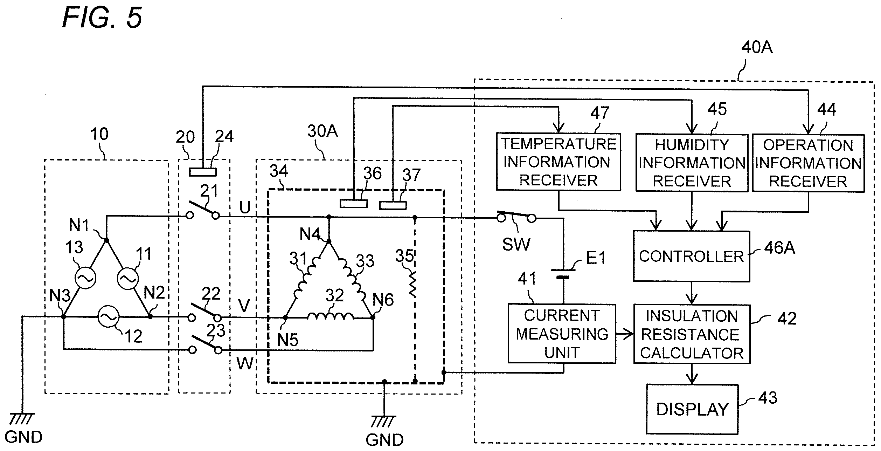

Fig. 5 is a block diagram showing an exemplary configuration of a motor system including an insulation resistance monitoring apparatus 40A according to a second embodiment. The motor system of Fig. 5 is provided with a three-phase motor apparatus 30A and an insulation resistance monitoring apparatus 40A, instead of the three-phase motor apparatus 30 and the insulation resistance monitoring apparatus 40 of Fig. 1.

The three-phase motor apparatus 30A is provided with a temperature sensor 37 that detects a temperature around the three-phase motor apparatus 30A, in addition to the components included in the three-phase motor apparatus 30A of Fig. 1. Here, being "around" the three-phase motor apparatus 30A implies a position at which the temperature sensor 37 can detect the temperature affecting the insulation resistance Ro of the three-phase motor apparatus 30A, e.g., a position inside of the housing 34.

The insulation resistance monitoring apparatus 40A is provided with a controller 46A, instead of the controller 46 of the insulation resistance monitoring apparatus 40 of Fig. 1, and further provided with a temperature information receiver 47.

The temperature information receiver 47 receives the temperature around the three-phase motor apparatus 30A from the temperature sensor 37, and notifies the controller 46A of the temperature.

When the three-phase motor apparatus 30A is not in operation; the humidity around the three-phase motor apparatus 30A is equal to or higher than the first threshold Th1; and the temperature around the three-phase motor apparatus 30A is equal to or higher than a predetermined second threshold Th2, the controller 46A controls the insulation resistance calculator 42 to calculate the insulation resistance Ro of the three-phase motor apparatus 30A, and to output the insulation resistance Ro on the display 43. The threshold Th2 is set such that the insulation resistance Ro of the three-phase motor apparatus 30A is sufficiently low, for example, set to 25° C.

### [EXEMPLARY OPERATION OF SECOND EMBODIMENT]

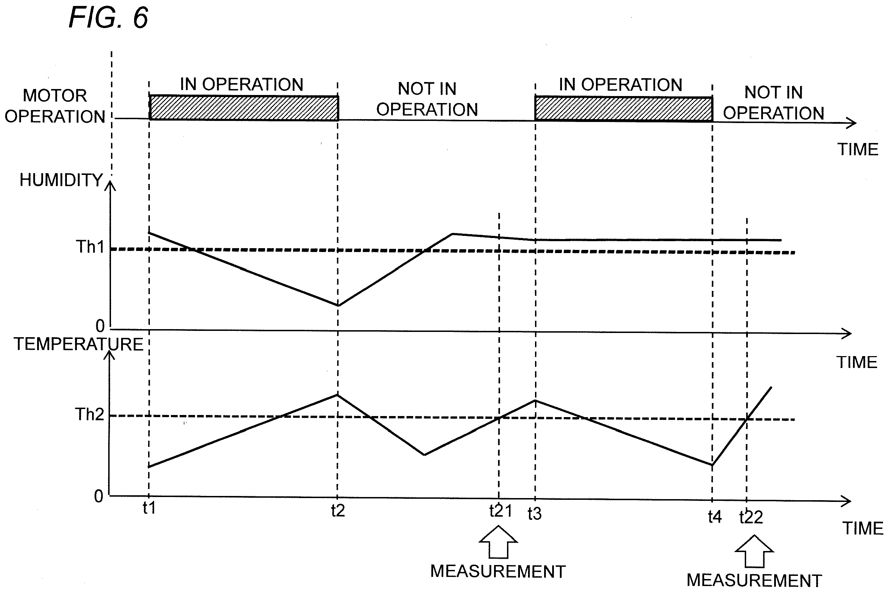

Fig. 6 is an exemplary timing chart showing measurements of the insulation resistance Ro of the three-phase motor apparatus 30A, conducted by the insulation resistance monitoring apparatus 40A shown in Fig. 5. In the example of Fig. 3, when the three-phase motor apparatus 30A is not in operation, the humidity and the temperature around the three-phase motor apparatus 30A are higher than the thresholds Th1 and Th2, respectively, at time t21 and time t22. As described above, when the three-phase motor apparatus 30A is not in operation; the humidity around the three-phase motor apparatus 30A is equal to or higher than the threshold Th1; and the temperature around the three-phase motor apparatus 30A is equal to or higher than the threshold Th2, the insulation resistance monitoring apparatus 40A measures and outputs the insulation resistance Ro of the three-phase motor apparatus 30A.

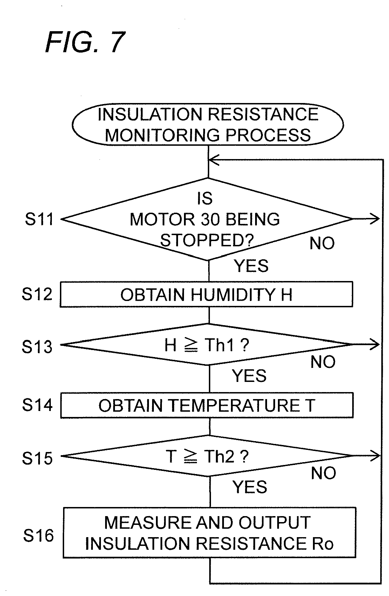

Fig. 7 is a flowchart showing an example of an insulation resistance monitoring process executed by the controller 46A of Fig. 5.

Step S11 to 13 are similar to steps S1 to S3 of Fig. 4.

In step S14, the controller 46A obtains the temperature T around the three-phase motor apparatus 30A from the temperature information receiver 47. In step S15, the controller 46A determines whether or not the temperature T around the three-phase motor apparatus 30A is equal to or higher than the threshold Th2: if YES, the process proceeds to step S16; if NO, the process returns to step S11.

In step S16, the controller 46A controls the insulation resistance calculator 42 to measure the insulation resistance Ro, and output the insulation resistance Ro on the display 43, in a similar manner to that of step S4 of Fig. 4

According to the insulation resistance monitoring process of Fig. 4, it is possible to accurately measure the insulation resistance Ro of the three-phase motor apparatus 30A, in consideration of the variations of the insulation resistance Ro due to variations in the humidity and the temperature around the three-phase motor apparatus 30A, and present the insulation resistance Ro to the user.

### [ADVANTAGEOUS EFFECTS OF SECOND EMBODIMENT]

The insulation resistance monitoring apparatus 40A according to the second embodiment can accurately measure the insulation resistance Ro of the three-phase motor apparatus 30A, in consideration of the variations of the insulation resistance Ro due to the variations in the humidity and the temperature around the three-phase motor apparatus 30A, and present the insulation resistance Ro to the user. By taking both the humidity and the temperature into consideration, it is possible to more accurately the insulation resistance Ro of the three-phase motor apparatus 30A and present it to the user, than that of the first embodiment.

### [THIRD EMBODIMENT]

An insulation resistance monitoring apparatus according to a third embodiment will now be explained.

### [EXEMPLARY CONFIGURATION OF THIRD EMBODIMENT]

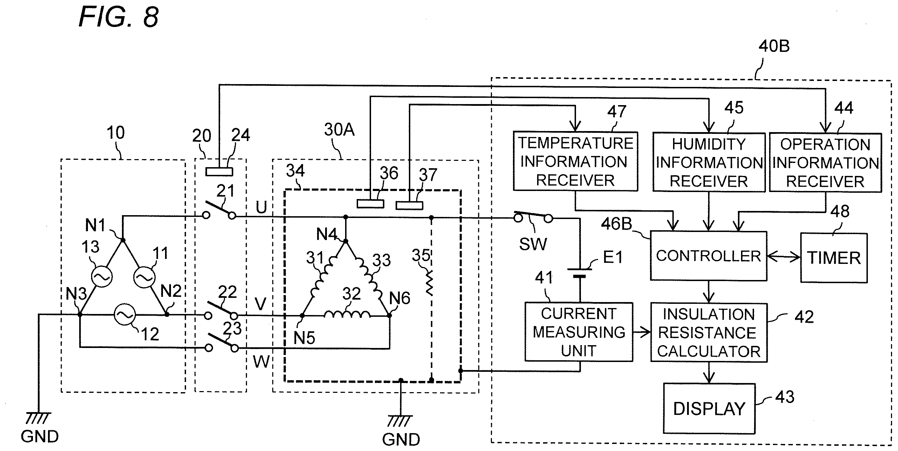

Fig. 8 is a block diagram showing an exemplary configuration of a motor system including an insulation resistance monitoring apparatus 40B according to a third embodiment. The motor system of Fig. 8 is provided with an insulation resistance monitoring apparatus 40B, instead of the insulation resistance monitoring apparatus 40A of Fig. 5.

The insulation resistance monitoring apparatus 40B is provided with a controller 46B, instead of the controller 46A of the insulation resistance monitoring apparatus 40A of Fig. 5, and further provided with a timer 48.

The timer 48 measures a time elapsed from when the three-phase motor apparatus 30A stopped operation.

The controller 46B controls the timer 48 to start or to stop measuring the time, based on the information from the operation information receiver 44. When the three-phase motor apparatus 30A has transitioned from the not-in-operation state to the in-operation state, the controller 46B starts the timer 48 to measure the time. When the three-phase motor apparatus 30A has transitioned from the in-operation state to the not-in-operation state, the controller 46B stops the timer 48 to measure the time and resets the timer 48. When the three-phase motor apparatus 30A is not in operation; a predetermined time period T0 has elapsed from when the three-phase motor apparatus 30A stopped operation; the humidity around the three-phase motor apparatus 30A is equal to or higher than the threshold Th1; and the temperature around the three-phase motor apparatus 30A is equal to or higher than the threshold Th2. The controller 46B controls the insulation resistance calculator 42 to measure and output the insulation resistance Ro of the three-phase motor apparatus 30A. The time period T0 is set such that the temperature around the three-phase motor apparatus 30A, which has increased during the operation of the three-phase motor apparatus 30A, is sufficiently reduced, for example, set to several minutes to several hours.

In general, since the three-phase motor apparatus 30A generates heat during the operation, the temperature around the three-phase motor apparatus 30A increases during the operation of the three-phase motor apparatus 30A, and the humidity decreases as the temperature increases. Therefore, when the insulation resistance Ro is measured immediately after the three-phase motor apparatus 30A has stopped operation, a temporarily increased insulation resistance Ro may be obtained due to the decrease in the humidity. On the other hand, by measuring the insulation resistance Ro after the time period T0 has elapsed from when the three-phase motor apparatus 30A stopped operation, it is possible to obtain a sufficiently low insulation resistance Ro.

### [EXEMPLARY OPERATION OF THIRD EMBODIMENT]

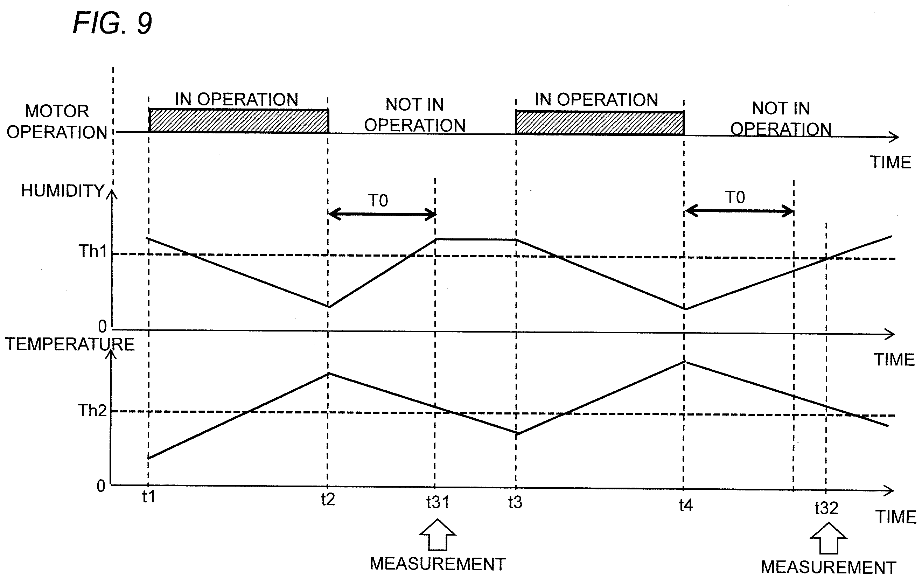

Fig. 9 is an exemplary timing chart showing measurements of the insulation resistance Ro of the three-phase motor apparatus 30, conducted by the insulation resistance monitoring apparatus 40B shown in Fig. 8. In the example of Fig. 9, after the three-phase motor apparatus 30A stopped operation at the time t2, even if the humidity and the temperature around the three-phase motor apparatus 30A are higher than the thresholds Th1 and Th2, respectively, the insulation resistance Ro of the three-phase motor apparatus 30A is not measured and outputted until the time period T0 elapses (that is, until time t31). In addition, after the three-phase motor apparatus 30A stopped operation at the time t2, even when the time period T0 elapses, the insulation resistance Ro of the three-phase motor apparatus 30A is not measured and outputted until the humidity and the temperature around the three-phase motor apparatus 30A become higher than the thresholds Th1 and Th2, respectively (that is, until time t32).

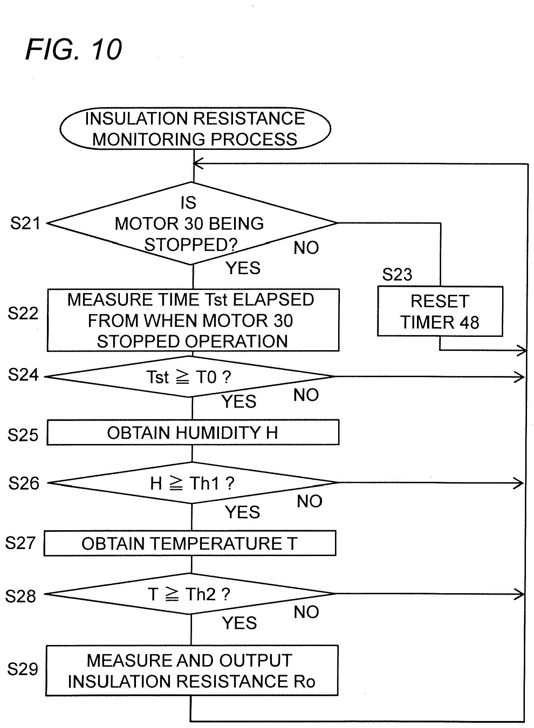

Fig. 10 is a flowchart showing an example of insulation resistance monitoring process executed by the controller 46B of Fig. 8.

In step S21, the controller 46B determines whether or not the three-phase motor apparatus 30A is being stopped (i.e., not in operation), based on the information from the operation information receiver 44: if YES (i.e., the three-phase motor apparatus 30A is not in operation), the process proceeds to step S22; if NO (i.e., the three-phase motor apparatus 30A is in operation), the process proceeds to step S23.

In step S22, the controller 46B measures a time Tst elapsed from when the three-phase motor apparatus 30A stopped operation, using the timer 48.

In step S23, the controller 46B resets the timer 48.

In step S24, the controller 46B determines whether or not the time Tst elapsed from when the three-phase motor apparatus 30A stopped operation is equal to or longer than the predetermined time period T0: if YES, the process proceeds to step S25; if NO, the process returns to step S21.

Steps S25 to S29 are similar to steps S12 to S16 of Fig. 7.

According to the insulation resistance monitoring process of Fig. 10, it is possible to avoid measuring and outputting the insulation resistance Ro of the three-phase motor apparatus 30A, when the humidity has decreased due to heating of the three-phase motor apparatus 30A. Therefore, it is possible to accurately measure the insulation resistance Ro of the three-phase motor apparatus 30A, and present the insulation resistance Ro to the user.

### [ADVANTAGEOUS EFFECTS OF THIRD EMBODIMENT]

The insulation resistance monitoring apparatus 40B according to the third embodiment can , it is possible to avoid measuring and outputting the insulation resistance Ro of the three-phase motor apparatus 30A, when the humidity has decreased due to heating of the three-phase motor apparatus 30A. Therefore, it is possible to accurately measure the insulation resistance Ro of the three-phase motor apparatus 30A, and present the insulation resistance Ro to the user.

### [FOURTH EMBODIMENT]

An insulation resistance monitoring apparatus according to a fourth embodiment will now be explained.

### [EXEMPLARY CONFIGURATION OF FOURTH EMBODIMENT]

Fig. 11 is a block diagram showing an exemplary configuration of a motor system including an insulation resistance monitoring apparatus 40C according to a fourth embodiment. The motor system of Fig. 11 is provided with an insulation resistance monitoring apparatus 40C, instead of the insulation resistance monitoring apparatus 40B of Fig. 8.

The insulation resistance monitoring apparatus 40C is provided with a controller 46C and a timer 48C, instead of the controller 46B and the timer 48 of the insulation resistance monitoring apparatus 40B of Fig. 8, and further provided with a storage 49.

The timer 48C measures the time elapsed from when a threshold setting process started. The threshold setting process will be described below with reference to Figs. 14 to 16.

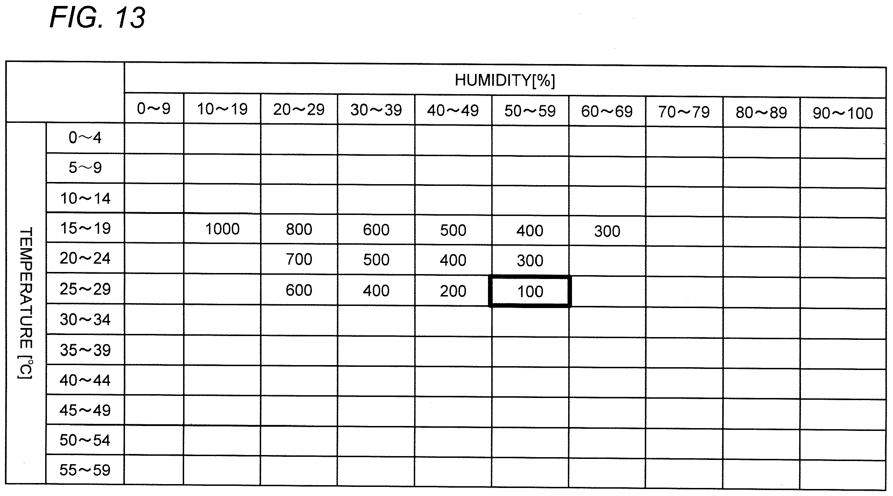

The storage 49 stores therein the insulation resistances Ro of the three-phase motor apparatus 30A measured by the insulation resistance measuring unit, and the humidity values and the temperature values around the three-phase motor apparatus 30A each obtained when a corresponding insulation resistance Ro of the three-phase motor apparatus 30A is measured. The storage 49 may store therein, for example, a table, which will be described with reference to Fig. 13.

The controller 46C controls the insulation resistance measuring unit to measure the insulation resistances of the device under measurement over a predetermined time period T1. The controller 46C then stores, in the storage 49, the insulation resistance Ro of the device under measurement measured by the insulation resistance measuring unit, and the humidity and the temperature around the device under measurement obtained when the insulation resistance Ro of the device under measurement is measured. The controller 46C then selects, as the threshold Th1, the humidity corresponding to a lowest insulation resistance Ro among a plurality of the insulation resistances Ro stored in the storage 49. In addition, the controller 46C selects, as the threshold Th2, the temperature corresponding to the lowest insulation resistance Ro among the plurality of insulation resistances Ro stored in the storage 49. In this manner, the controller 46C sets the humidity threshold Th1 and the temperature threshold Th2. The time period T1 is set to a time length enough for obtaining a sufficient number of combinations of the insulation resistance Ro, the humidity, and the temperature to set the thresholds Th1 and Th2, for example, set to several days to several weeks..

### [EXEMPLARY OPERATION OF FOURTH EMBODIMENT]

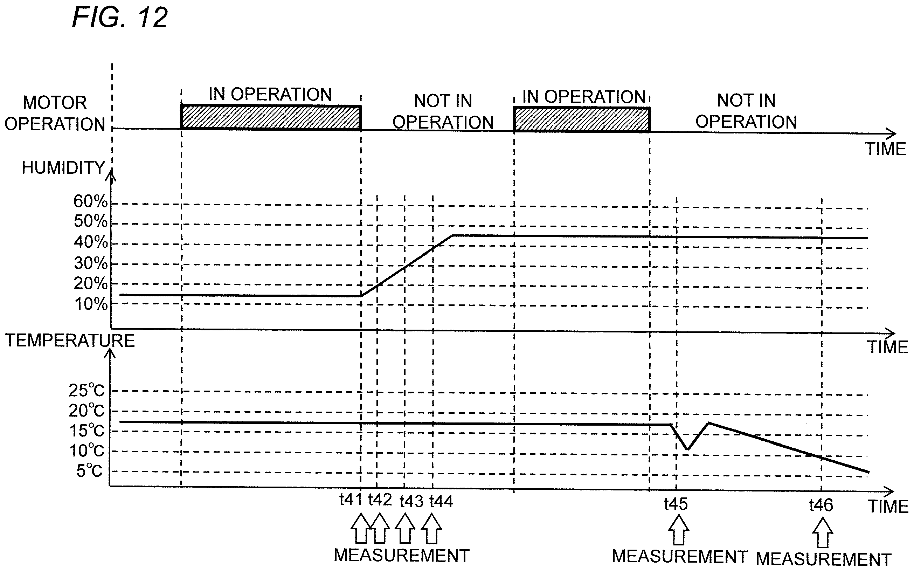

Fig. 12 is an exemplary timing chart showing measurements of the insulation resistance of the three-phase motor apparatus 30A, conducted by the insulation resistance monitoring apparatus 40C shown in Fig. 11. The insulation resistance monitoring apparatus 40C measures the insulation resistance Ro every time the humidity or the temperature changes by a predetermined step width, while the three-phase motor apparatus 30A is not in operation. In the example of Fig. 12, the step width for humidity is set to 10%, and the step width for temperature is set to 5°C. In the example of Fig. 12, the insulation resistance monitoring apparatus 40C measures the insulation resistance Ro at time t41 to t46. As a result, the insulation resistance monitoring apparatus 40C obtains a plurality of insulation resistances Ro each being measured corresponding to a different combination of the humidity and the temperature.

Fig. 13 is a table showing the insulation resistance Ro of the three-phase motor apparatus 30A measured by the insulation resistance monitoring apparatus 40C of Fig. 11 under various humidity and temperature conditions. For example, every time the humidity and the temperature reach values for a combination of which the insulation resistance Ro has not been measured yet, the insulation resistance monitoring apparatus 40C measures the insulation resistance Ro, and stores the measured insulation resistance Ro in the storage 49 in association with the humidity and the temperature. When a predetermined time period, e.g., three days, has elapsed, the data shown in Fig. 13 is stored in the storage 49. In Fig. 13, the unit of the insulation resistance Ro is MΩ, and blank cells indicate that the insulation resistance Ro has not been measured yet. In the example of Fig. 13, the lowest insulation resistance Ro is 100 MΩ, and therefore, the humidity threshold Th1 is set to 50%, and the temperature threshold Th2 is set to 25°C, accordingly.

Fig. 14 is a flowchart showing an example of insulation resistance monitoring process executed by the controller 46C of Fig. 11.

In step S31, the controller 46C determines whether the thresholds Th1 and Th2 are not yet set: if NO (i.e., the thresholds Th1 and Th2 are not yet set), the process proceeds to step S32; if YES (i.e., the thresholds Th1 and Th2 have been set), the process proceeds to step 33.

In step S32, the controller 46C executes threshold setting process, which is to be described below with reference to Fig. 15.

In step S33, the controller 46C executes the insulation resistance measurement process. The insulation resistance measurement process of step S33 is similar to the insulation resistance monitoring process described with reference to Fig. 4, 7, or 10.

Fig. 15 is a flowchart showing a subroutine of the threshold setting process of step S32 in Fig. 14.

In step S41, the controller 46C determines whether or not the three-phase motor apparatus 30A is being stopped (i.e., not in operation), based on the information from the operation information receiver 44: if YES (i.e., the three-phase motor apparatus 30A is not in operation), the process proceeds to step S2; if NO (i.e., the three-phase motor apparatus 30A is in operation), step S1 is repeated.

In step S42, the controller 46C obtains the humidity H around the three-phase motor apparatus 30A from the humidity information receiver 45, and obtains the temperature T around the three-phase motor apparatus 30A from the temperature information receiver 47. In step S43, the controller 46C determines whether the insulation resistance Ro corresponding to the current humidity H and temperature T has not been measured yet: if NO (i.e., the insulation resistance Ro has not been measured yet), the process proceeds to step S44; if YES (i.e., the insulation resistance Ro has been measured), the process returns to step S41.

In step S44, the controller 46C controls the insulation resistance calculator 42 to measure the insulation resistance Ro. In step S45, the controller 46C stores the insulation resistance Ro in the storage 49, together with the humidity H and the temperature T.

In step S46C, the controller 46C determines whether the predetermined measurement period T1 has elapsed from when the threshold setting process has started: if YES, the process proceeds to step S47; if NO, the process returns to step S41.

In step S47, the controller 46C sets the humidity H corresponding to the lowest insulation resistance Ro, as the threshold Th1. In step S48, the controller 46C sets the temperature T corresponding to the lowest insulation resistance Ro, as the threshold Th2.

Step S32 is executed, for example, when the insulation resistance monitoring apparatus 40C operates for the first time after the installation of the motor system. Once step S32 is executed, it is possible to execute the insulation resistance measurement process of step S33, using the thresholds Th1 and Th2 being set.

When there are a plurality of lowest insulation resistance measurements, the lowest one of a plurality of humidity values corresponding to the insulation resistance may be selected as the threshold Th1, and the lowest one of a plurality of temperature values corresponding to the insulation resistance may be selected as the threshold Th2.

According to the insulation resistance monitoring process of Fig. 14, by executing the threshold setting process of step S32, it is possible to automatically set appropriate humidity threshold Th1 and temperature threshold Th2, based on the surrounding environment of the three-phase motor apparatus 30A, and accurately measure the insulation resistance Ro of the three-phase motor apparatus 30A. In addition, by automatically setting the thresholds Th1 and Th2, it is possible to alleviate user's efforts.

When the surrounding environment of the three-phase motor apparatus 30A changes after the threshold setting process of step S32 is executed, for example, when the average humidity and the average temperature (air temperature) decrease as the season changes, the humidity and the temperature around the three-phase motor apparatus 30A may be less likely to reach the thresholds Th1 and Th2, respectively. As a result, the insulation resistance Ro of the three-phase motor apparatus 30A may be unable to be measured for a long time. Therefore, when the insulation resistance Ro of the three-phase motor apparatus 30A can not be measured for a long time, the thresholds Th1 and Th2 are set again, as will be described below with reference to Fig. 16.

Fig. 16 is a flowchart showing a modification of the insulation resistance monitoring process executed by the controller 46C of Fig. 11.

In step S51, the controller 46C determines whether or not the period in which the insulation resistance Ro is not measured exceeds a threshold T2: if YES, the process proceeds to step S52; if NO, the process proceeds to step S53. The threshold T2 is set to, for example, one week.

In step S52, the controller 46C executes a threshold resetting process. The threshold resetting process of step S52 is similar to the threshold setting process of step S32.

In step S53, the controller 46C executes the insulation resistance measurement process. The insulation resistance measurement process of step S53 is similar to the insulation resistance monitoring process described with reference to Fig. 4, 7, or 10, except that the process proceeds to step 51 of Fig. 16 instead of returning back to the first step in the insulation resistance monitoring process of Fig. 4, 7, or 10.

According to the insulation resistance monitoring process of Fig. 16, even if the surrounding environment of the three-phase motor apparatus 30A varies, by setting the thresholds Th1 and Th2 again, it is possible to prevent failure in measurement of the insulation resistance Ro of the three-phase motor apparatus 30A for a long time.

### [ADVANTAGEOUS EFFECTS OF FOURTH EMBODIMENT]

According to the insulation resistance monitoring apparatus 40C of the fourth embodiment, by executing the insulation resistance monitoring process of Fig. 14, it is possible to automatically set appropriate humidity threshold Th1 and temperature threshold Th2, based on the surrounding environment of the three-phase motor apparatus 30A, and accurately measure the insulation resistance Ro of the three-phase motor apparatus 30A. In addition, according to the insulation resistance monitoring apparatus 40C of the fourth embodiment, by executing the insulation resistance monitoring process of Fig. 16, it is possible to automatically set appropriate humidity threshold Th1 and temperature threshold Th2 again, based on the surrounding environment of the three-phase motor apparatus 30A. In this manner, even if the surrounding environment of the three-phase motor apparatus 30A varies, it is possible to prevent failure in measurement of the insulation resistance Ro of the three-phase motor apparatus 30A for a long time.

### [OTHER EMBODIMENTS]

Although the embodiments of the present disclosure have been described in detail above, the above descriptions are mere examples of the present disclosure in all respects. Needless to say, various improvements and modifications can be made without departing from the scope of the present disclosure. For example, the following changes can be made. Hereinafter, components similar to those of the above embodiments are indicated by similar reference signs, and points similar to those of the above embodiments will be omitted as appropriate. The following modified embodiments can be combined as appropriate.

The humidity sensor 36 may be provided inside the housing 34 as shown in Fig. 1 and others, or alternatively, may also be provided outside the housing 34 as long as the humidity sensor 36 can detect the humidity affecting the insulation resistance Ro of the three-phase motor apparatus 30, 30A. Similarly, the temperature sensor 37 may be provided inside the housing 34 as shown in Fig. 5 and others, or alternatively, may also be provided outside the housing 34 as long as the temperature sensor 37 can detect the temperature affecting the insulation resistance Ro of the three-phase motor apparatus 30A.

The operation information receiver 44 may receive information indicating whether or not the three-phase motor apparatus 30, 30A is in operation, from the operation sensor 24 provided in the circuit breaker 20, as shown in Fig. 1 and others, or alternatively, receive the information from a further controller (not shown) that controls the circuit breaker 20. In addition, the humidity information receiver 45 may receive the humidity around the three-phase motor apparatus 30, 30A from the humidity sensor 36 provided in the three-phase motor apparatus 30, 30A, as shown in Fig. 1 and others, or alternatively, may also receive the humidity from a further measuring unit that measures the humidity around the three-phase motor apparatus 30, 30A. In addition, the temperature information receiver 47 may receive the temperature around the three-phase motor apparatus 30A from the temperature sensor 37 provided in the three-phase motor apparatus 30A, as shown in Fig. 5 and the like, or alternatively, may also receive the temperature from a further measuring unit that measures the temperature around the three-phase motor apparatus 30A.

The insulation resistance monitoring apparatus 40, 40A to 40C may be configured to measure and output the insulation resistance Ro of the three-phase motor apparatus 30, 30A, when the three-phase motor apparatus 30, 30A is not in operation, and the humidity around the three-phase motor apparatus 30, 30A is within a predetermined range. In addition, the insulation resistance monitoring apparatus 40A to 40C may be configured to measure and output the insulation resistance Ro of the three-phase motor apparatus 30A, when the three-phase motor apparatus 30A is not in operation, the humidity around the three-phase motor apparatus 30A is within a predetermined range, and the temperature around the three-phase motor apparatus 30A is within a predetermined range. In the example of Fig. 13, since the lowest insulation resistance Ro is 100 MΩ, the humidity range is set to 50 % to 56 %, and the temperature range is set to 25°C to 29°C, accordingly. When the surrounding environment of the three-phase motor apparatus 30A varies, for example, when the average humidity and the average temperature (air temperature) increase, the humidity and the temperature around the three-phase motor apparatus 30A may be more likely to exceed predetermined humidity range and temperature range, respectively. In this case, it is possible to automatically set the appropriate humidity range and temperature range again, based on the surrounding environment of the three-phase motor apparatus 30A, in a similar manner to that of the insulation resistance monitoring process of Fig. 16. In this manner, it is possible to prevent failure in measurement of the insulation resistance Ro of the three-phase motor apparatus 30A for a long time.

In the third embodiment, an example is described in which the insulation resistance monitoring apparatus 40B obtains both the humidity and the temperature around the three-phase motor apparatus 30A, but the insulation resistance monitoring apparatus 40B may obtain only one of the humidity and the temperature. In this case, when the three-phase motor apparatus 30A is not in operation, the predetermined time period T0 has elapsed from when the three-phase motor apparatus 30A stopped operation, and the humidity or temperature around the three-phase motor apparatus 30A is equal to or higher than the threshold, the insulation resistance monitoring apparatus 40B measures and outputs the insulation resistance Ro of the three-phase motor apparatus 30A.

In the fourth embodiment, is an example is described in which the insulation resistance monitoring apparatus 40C sets both the humidity threshold Th1 and the temperature threshold Th2 automatically, but the insulation resistance monitoring apparatus 40C may set only one of the thresholds Th1 and Th2 automatically.

The insulation resistance monitoring apparatus 40, 40A to 40C of Fig. 1 and others is not limited to the insulation resistance calculator provided with the current measuring unit 41, the insulation resistance calculator 42, the display 43, the voltage source E1, and the switch SW, and may be provided with an insulation resistance calculator having any other configuration.

The display 43 may be provided in a remote device connected via a communication line, instead inside of the insulation resistance monitoring apparatus 40, 40A to 40C.

The calculation result and the determination result of the insulation resistance calculator 42 may be outputted audibly, using an audio output device, instead of being outputted visually using the display 43. In addition, any other output device may be used to notify the user of the calculation result and the determination result of the insulation resistance calculator 42. In addition, the insulation resistance monitoring apparatus 40, 40A to 40C may output the calculation result and the determination result of the insulation resistance calculator 42 to a further device connected over a communication line.

In the embodiments, the examples are described in which the insulation resistance monitoring apparatus 40, 40A to 40C is connected to the node N4 and the housing 34 of the three-phase motor apparatus 30, 30A. However, the insulation resistance monitoring apparatus 40, 40A to 40C may be connected between the node N5 and the housing 34, or may be connected between the node N6 and the housing 34.

The insulation resistance monitoring apparatus 40, 40A to 40C may be connected between two mutually insulated nodes of any other device under measurement, instead of the three-phase motor apparatus 30, 30A. Examples of the device under measurement include a power supply, a timer, a relay, a common socket, a DIN rail, a waterproof cover, a temperature regulator, a switch, and the like. In addition, the insulation resistance monitoring apparatus 40 may be connected to any two mutually insulated nodes of the device under measurement, without limitation to the power line and the ground conductor of the device under measurement.

### [SUMMARY OF EMBODIMENT]

The insulation resistance monitoring apparatus according to each aspect of the present disclosure may be expressed as follows.

According an insulation resistance monitoring apparatus 40 of an aspect of the present disclosure, an insulation resistance monitoring apparatus 40 is provided with: an insulation resistance measuring unit, an operation information receiver 44, a humidity information receiver 45, and a controller 46. The insulation resistance measuring unit is configured to measure and output an insulation resistance of a device under measurement. The operation information receiver 44 is configured to receive information indicating whether or not the device under measurement is in operation. The humidity information receiver 45 is configured to receive humidity around the device under measurement. The controller 46 is configured to control the insulation resistance measuring unit to measure and output the insulation resistance of the device under measurement, when the device under measurement is not in operation, and the humidity around the device under measurement is equal to or higher than a first threshold Th1.

According an insulation resistance monitoring apparatus 40B of an aspect of the present disclosure, the insulation resistance monitoring apparatus 40B is further provided with a timer configured to measure a time elapsed from when the device under measurement stopped operation. When the device under measurement is not in operation, a predetermined first time period has elapsed from when the device under measurement stopped operation, and the humidity around the device under measurement is equal to or higher than the first threshold Th1, the controller 46B controls the insulation resistance measuring unit to measure and output the insulation resistance of the device under measurement.

According an insulation resistance monitoring apparatus 40C of an aspect of the present disclosure, the insulation resistance monitoring apparatus 40C is further provided with a storage 49 configured to store the insulation resistance of the device under measurement measured by the insulation resistance measuring unit. The controller 46C is configured to set the first threshold Th1 by: controlling the insulation resistance measuring unit to measure the insulation resistance of the device under measurement over a predetermined second time period; storing, in the storage 49, the insulation resistance of the device under measurement measured by the insulation resistance measuring unit, and the humidity around the device under measurement received when measuring the insulation resistance of the device under measurement; and selecting humidity corresponding to a lowest insulation resistance among a plurality of insulation resistances stored in the storage 49, as the first threshold Th1.

According an insulation resistance monitoring apparatus 40C of an aspect of the present disclosure, the controller 46C is configured to set the first threshold Th1, when a period in which the humidity around the device under measurement is lower than the first threshold Th1 exceeds a predetermined third time period.

According an insulation resistance monitoring apparatus 40A of an aspect of the present disclosure, the insulation resistance monitoring apparatus 40A is further provided with a temperature information receiver configured to receive a temperature around the device under measurement. When the device under measurement is not in operation, the humidity around the device under measurement is equal to or higher than the first threshold Th1, and the temperature around the device under measurement is equal to or higher than a second threshold Th2, the controller 46A controls the insulation resistance measuring unit to measure and output the insulation resistance of the device under measurement.

According an insulation resistance monitoring apparatus 40B of an aspect of the present disclosure, the insulation resistance monitoring apparatus 40B is further provided with a timer configured to measure a time elapsed from when the device under measurement stopped operation. When the device under measurement is not in operation, a predetermined first time period has elapsed from when the device under measurement has stopped operation, the humidity around the device under measurement is equal to or higher than the first threshold Th1, and the temperature around the device under measurement is equal to or higher than the second threshold Th2, the controller 46B controls the insulation resistance measuring unit to measure and output the insulation resistance of the device under measurement.

According an insulation resistance monitoring apparatus 40C of an aspect of the present disclosure, the insulation resistance monitoring apparatus 40C is further provided with a storage 49 configured to store the insulation resistance of the device under measurement measured by the insulation resistance measuring unit. The controller 46C is configured to set the second threshold Th2 by: controlling the insulation resistance measuring unit to measure the insulation resistance of the device under measurement over a predetermined second time period; storing, in the storage 49, the insulation resistance of the device under measurement measured by the insulation resistance measuring unit, and the temperature around the device under measurement received when the insulation resistance of the device under measurement is measured; and selecting a temperature corresponding to a lowest insulation resistance among a plurality of the insulation resistances stored in the storage 49, as the second threshold Th2.

According an insulation resistance monitoring apparatus 40C of an aspect of the present disclosure, the controller 46C sets the second threshold Th2, when a period in which the temperature around the device under measurement is less than the second threshold Th2 exceeds a predetermined third time period.

### INDUSTRIAL APPLICABILITY

According to the insulation resistance monitoring apparatus of one aspect of the present invention, it is possible to accurately measure the insulation resistance of the device under measurement, in consideration of the variations in the insulation resistance due to the surrounding environment of the device under measurement.

### REFERENCE SIGNS LIST

10: three-phase AC power supply apparatus
11 to 13: single-phase AC power supply
20: circuit breaker
21 to 23: switch
24: operation sensor
30, 30A: three-phase motor apparatus
31 to 33: winding
34: housing
35: line-to-ground insulation resistor
36: humidity sensor
37: temperature sensor
40, 40A to 40C: insulation resistance monitoring apparatus
41: current measuring unit
42: insulation resistance calculator
43: display
44: operation information receiver
45: humidity information receiver
46, 46A to 46C: controller
47: temperature information receiver
48, 48C: timer
49: storage
E1: voltage source
SW: switch

## Claims

1. An insulation resistance monitoring apparatus comprising:
an insulation resistance measuring unit configured to measure and output an insulation resistance of a device under measurement;
an operation information receiver configured to receive information indicating whether or not the device under measurement is in operation;
a humidity information receiver configured to receive humidity around the device under measurement; and
a controller configured to control the insulation resistance measuring unit to measure and output the insulation resistance of the device under measurement, when the device under measurement is not in operation, and the humidity around the device under measurement is equal to or higher than a first threshold.

2. The insulation resistance monitoring apparatus as claimed in claim 1, further comprising a timer configured to measure a time elapsed from when the device under measurement stopped operation,
wherein, when the device under measurement is not in operation, a predetermined first time period has elapsed from when the device under measurement stopped operation, and the humidity around the device under measurement is equal to or higher than the first threshold, the controller controls the insulation resistance measuring unit to measure and output the insulation resistance of the device under measurement.

3. The insulation resistance monitoring apparatus as claimed in claim 1 or 2, further comprising a storage configured to store the insulation resistance of the device under measurement measured by the insulation resistance measuring unit,
wherein the controller is configured to set the first threshold by:
controlling the insulation resistance measuring unit to measure the insulation resistance of the device under measurement over a predetermined second time period;
storing, in the storage, the insulation resistance of the device under measurement measured by the insulation resistance measuring unit, and the humidity around the device under measurement received when measuring the insulation resistance of the device under measurement; and
selecting humidity corresponding to a lowest insulation resistance among a plurality of insulation resistances stored in the storage, as the first threshold.

4. The insulation resistance monitoring apparatus as claimed in claim 3,
wherein the controller is configured to set the first threshold, when a period in which the humidity around the device under measurement is lower than the first threshold exceeds a predetermined third time period.

5. The insulation resistance monitoring apparatus as claimed in any one of claims 1 to 4, further comprising a temperature information receiver configured to receive a temperature around the device under measurement,
wherein, when the device under measurement is not in operation, the humidity around the device under measurement is equal to or higher than the first threshold, and the temperature around the device under measurement is equal to or higher than a second threshold, the controller controls the insulation resistance measuring unit to measure and output the insulation resistance of the device under measurement.

6. The insulation resistance monitoring apparatus as claimed in claim 5, further comprising a timer configured to measure a time elapsed from when the device under measurement stopped operation,
wherein, when the device under measurement is not in operation, a predetermined first time period has elapsed from when the device under measurement has stopped operation, the humidity around the device under measurement is equal to or higher than the first threshold, and the temperature around the device under measurement is equal to or higher than the second threshold, the controller controls the insulation resistance measuring unit to measure and output the insulation resistance of the device under measurement.

7. The insulation resistance monitoring apparatus as claimed in claim 5 or 6, further comprising a storage configured to store the insulation resistance of the device under measurement measured by the insulation resistance measuring unit,
wherein the controller is configured to set the second threshold by:
controlling the insulation resistance measuring unit to measure the insulation resistance of the device under measurement over a predetermined second time period;
storing, in the storage, the insulation resistance of the device under measurement measured by the insulation resistance measuring unit, and the temperature around the device under measurement received when the insulation resistance of the device under measurement is measured; and
selecting a temperature corresponding to a lowest insulation resistance among a plurality of the insulation resistances stored in the storage, as the second threshold.

8. The insulation resistance monitoring apparatus as claimed in claim 7,
wherein the controller sets the second threshold, when a period in which the temperature around the device under measurement is less than the second threshold exceeds a predetermined third time period.
